# EUROPÄISCHE PATENTSCHRIFT

(11) **EP 0 316 296 B1**
(45) Veröffentlichungstag und Bekanntmachung des Hinweises auf die Patenterteilung: **13.04.1994**
(21) Anmeldenummer: 88890271.5
(22) Anmeldetag: 31.10.1988
(51) Int. Cl.: H01L 21/00

(54) **Träger für scheibenförmige Gegenstände und Vorrichtung zum Ätzen von Siliziumscheiben mit einem solchen Träger**
Holder for disc-like articles, and device for etching silicon chips with such a holder
Support pour objets en forme de disque et dispositif de décapage de plaquettes de silicium avec un tel support

(30) Priorität: 09.11.1987 AT 2958/87
(43) Veröffentlichungstag der Anmeldung: 17.05.1989
(60) Teilanmeldung: 91104986.4
(73) Patentinhaber: SEZ Semiconductor-Equipment Zubehör für die Halbleiterfertigung Gesellschaft m.b.H., A-9530 Bad Bleiberg 129 (Kärnten) (AT)
(72) Erfinder: Sumnitsch, Franz, A-9020 Klagenfurt Kärnten (AT)
(74) Vertreter: Beer, Manfred, Dipl.-Ing.

(56) Entgegenhaltungen:
- EP-A- 0 048 995
- EP-A- 0 129 108
- US-A- 4 131 267

## Beschreibung

Die Erfindung betrifft einen Träger für scheibenförmige Gegenstände, insbesondere für Siliziumscheiben während des Ätzens derselben, mit wenigstens einer Ringdüse in der dem Gegenstand zugekehrten, vorzugsweise kreisrunden Fläche des Trägers, die mit Druckgas zur Ausbildung eines Gaspolsters zwischen dem Träger und dem scheibenförmigen Gegenstand beaufschlagbar ist, und deren Austrittsöffnung mit der dem Gegenstand zugekehrten Fläche des Trägers einen spitzen Winkel (α) einschließt, wobei der Träger aus zwei oder drei rotationssymmetrischen, gleichachsigen Teilen besteht, und wobei zwischen den Teilen ein ringförmiger Raum vorgesehen ist, der zur Ringdüse ausmündet.

Beim Bearbeiten von scheibenförmigen Gegenständen, beispielsweise beim einseitigen Ätzen von Siliziumscheiben (Wafers) mit verschiedenen Säuren, ist es bislang notwendig, die nicht zu behandelnde Seite der Scheiben d.h. die Seite von Siliziumscheiben, die nicht geätzt werden soll, durch besondere Maßnahmen vor dem Angriff der Ätzflüssigkeiten zu schützen.

Aus IBM TECHNICAL DISCLOSURE BULLETIN Vol. 11 Nr. 2, Juli 1968, ist eine Vorrichtung zum Aufnehmen von Wafers bekannt, die nach dem Bernoulli-Prinzip arbeitet, wobei über einen mittigen Kanal Gas zugeführt und das zugeführte Gas durch eine Ringdüse, die innerhalb des Randes des Wafers angeordnet ist, wieder abgezogen wird. Ein Gasaustritt zwischen dem Körper des Trägers und dem Wafer ist somit nicht vorgesehen.

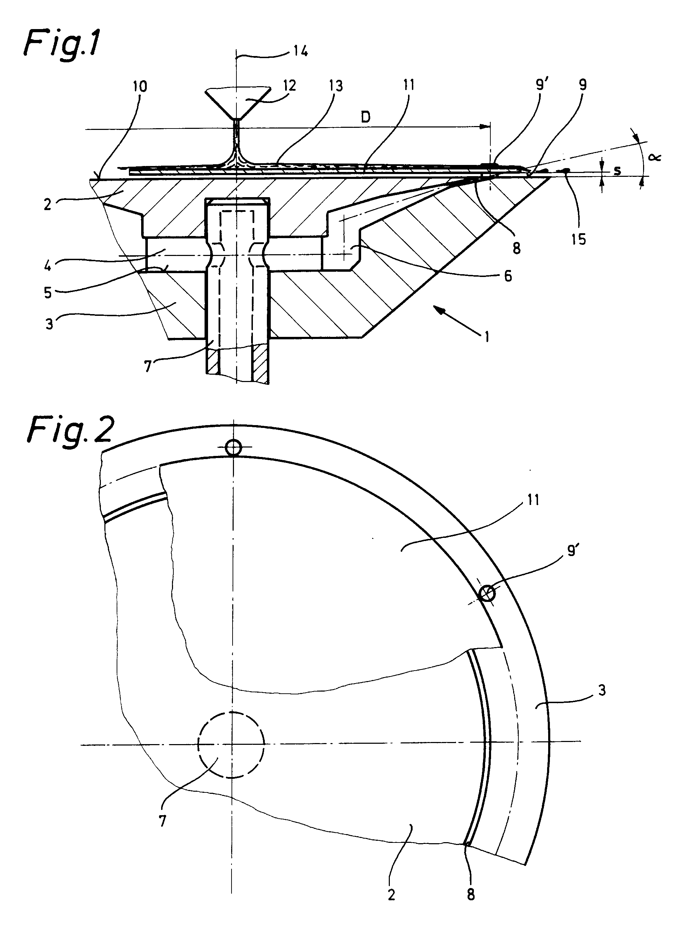

Dies gilt auch für die in IBM TECHNICAL DISCLOSURE BULLETIN, Vol. 20, Nr. 2, Juli 1977 gezeigte Vorrichtung, wozu insbesondere auf die dortige Fig. 2 verwiesen wird.

Die US-A-3 523 706 und das im vorliegenden Zusammenhang im wesentlichen offenbarungsgleiche IBM TECHNICAL DISCLOSURE BULLETIN, Vol. 18, Nr. 6, November 1975, zeigen jeweils eine Vorrichtung zum Aufnehmen von Scheiben, die nach dem Bernoulli-Prinzip arbeitet, wobei, wie aus Fig. 1a der US-A-3 523 706 ersichtlich, mehrere Düsen vorgesehen sind, die schräg zur der zu aufnehmenden Scheibe zugekehrten Fläche der Aufnahmevorrichtung ausgerichtet sind.

Diese bekannten Vorrichtungen sind demnach nicht geeignet, das Eindringen von Behandlungsflüssigkeit auf die Unterseite der Scheiben zu verkleinern.

In der EP-A-0 048 995, die einen Träger mit den Merkmalen des einleitenden Teils von Anspruch 1 zeigt, ist als Aufgabe angegeben, eine von einem Kristallstab abzutrennende Scheibe festzuhalten, ohne daß es zu Kratzern oder Randausbrüchen an der Scheibe kommt. Diese Randausbrüche werden nach den Ausführungen in der EP-A-0 048 995 unter anderem dadurch verursacht, daß die Scheibe an seitliche Abstützungen anschlägt, wenn sie vom Träger gehalten wird. In der EP-A-0 048 995 werden seitliche Anschläge am Träger als nachteilig angesehen, da die Scheibe am Träger flattern kann, so daß es zu Randausbrüchen kommen kann. In der EP-A-0 048 995 wird daher vorgeschlagen, daß die Haltefläche des Haltewerkzeuges, das sich im übrigen nicht dreht, im Zentrum eine punktförmig auslaufende Erhöhung aufweisen soll.

Der aus der EP-A-0 048 995 bekannte Träger weist jedoch den wesentlichen Nachteil auf, daß es zu einem Verwerfen oder Verbiegen der Scheibe kommen kann, wenn die Scheibe durch den Unterdruck zu stark an den Träger angesaugt wird, da die Scheibe nur punktförmig abgestützt wird.

Der Erfindung liegt die Aufgabe zugrunde, einen Träger der eingangs genannten Gattung anzugeben, mit dem scheibenförmige Gegenstände, insbesondere Siliziumscheiben behandelt werden können, ohne daß die nicht zu behandelnde Seite des scheibenförmigen Gegenstandes durch besondere Maßnahmen vor Angriff durch die Behandlungsflüssigkeit geschützt werden muß.

Erfindungsgemäß wird diese Aufgabe durch einen Träger gemäß Anspruch 1 gelöst, wobei nach oben vorstehende, entlang des Randes der dem Gegenstand zugekehrten Fläche des Trägers gleichmäßig verteilte Nocken zur seitlichen Abstützung des scheibenförmigen Gegenstandes vorgesehen sind und daß die Nocken bezüglich der Mittelachse des Trägers radial verstellbar sind.

Mit dem erfindungsgemäßen Träger ist sichergestellt, daß der zu behandelnde scheibenförmige Gegenstand, ohne auf dem Träger selbst flächig aufzuliegen, an diesem sicher gehalten ist. Weiters bewirkt das dem Träger zugeführte, aus der Düse austretende Gas, das den Gaspolster bildet, auf dem der Gegenstand liegt, daß vom Rand des zu behandelnden Gegenstandes wegströmende Flüssigkeit nicht auf die nicht zu behandelnde Unterseite des scheibenförmigen Gegenstandes gelangen kann, sondern von dem Rand des scheibenförmigen Gegenstandes weggeblasen wird. Bei Verwendung des erfindungsgemäßen Trägers ist auch gewährleistet, daß die Behandlungsflüssigkeit nicht durch Kapillarwirkung zwischen die dem scheibenförmigen Gegenstand zugekehrte Fläche des Trägers und dem scheibenförmigen Gegenstand hineingesaugt wird.

Durch die gemäß der Erfindung vorgesehenen, entlang des Randes der dem Gegenstand zugekehrten Fläche des Trägers gleichmäßig verteilten, nach oben vorstehenden Nocken, die als seitliche Anschläge für den Gegenstand dienen, wird das Abströmen des Druckgases aus der Düse und zwischen dem Rand des scheibenförmigen Gegenstandes und der diesem zugekehrten Fläche des Trägers nicht behindert.

Da die Nocken radial verstellbar sind, kann die zu behandelnde Scheibe bei Bedarf zwischen den Nocken geklemmt werden. Hiezu können die Nocken als Exzenter ausgebildet sein, denen der Einfachheit halber ein gemeinsamer Antrieb zur Verdrehung (z.B. Zahnkranz/Ritzel) zugeordnet sein kann.

Da insbesondere bei Behandlung von Siliziumscheiben diese Scheiben in der Regel kreisrund sind, ist die erfindungsgemäß vorgesehene Ringdüse besonders günstig.

Im Rahmen der Erfindung, ganz gleich ob mehrere ringförmig angeordnete Einzeldüsen oder eine durchgehende Ringdüse vorgesehen ist, ist es von Vorteil, daß die Austrittsöffnung der Düse mit der dem Gegenstand zugekehrten Fläche des Trägers einen spitzen Winkel α einschließt. Durch diese Maßnahme wird unter Ausnützung des aerodynamischen Paradoxon gewährleistet, daß weitestgehend unabhängig vom Druck des aus der Düse ausströmenden Gases der Abstand des scheibenförmigen Gegenstandes von der ihm zugekehrten Fläche des Trägers konstant gehalten, und ein Wegblasen des Gegenstandes vom Träger verhindert wird.

Im Rahmen der Erfindung bewährt es sich, wenn der Träger am Ende einer hohl ausgebildeten Welle angeordnet ist, deren Innenraum mit dem Raum zwischen den beiden Teilen des Trägers zur Beaufschlagung mit Druckgas in Verbindung steht. Auf diese Weise ist die Zufuhr von Druckgas zur Düse besonders einfach.

Weiters kann im Rahmen der Erfindung vorgesehen sein, daß der äußere Teil des Trägers eine Ringfläche aufweist, die den radial äußeren Bereich der dem Gegenstand zugekehrten Fläche des Trägers bildet, wobei dieser Teil vorzugsweise aus Kunststoff gefertigt ist. In diesem Fall bewährt es sich weiters, wenn der Deckel eine Kreisfläche aufweist, die den radial inneren Bereich der dem Gegenstand zugekehrten Fläche des Trägers bildet, wobei dieser Deckel vorzugsweise aus Metall gefertigt ist. Auf diese Weise kann die sehr schmal ausgebildete Ringdüse des Trägers in besonders einfacher Weise hergestellt werden.

Weitere Einzelheiten und Merkmale der Erfindung ergeben sich aus der nachstehenden Beschreibung der in den Zeichnungen schematisch dargestellten Ausführungsbeispiele. Es zeigt
Fig. 1 im Schnitt teilweise einen Träger,
Fig. 2 eine Draufsicht hiezu,
Fig. 3 schematisch eine Vorrichtung zum Ätzen von Siliziumscheiben, mit einem Träger gemäß den Fig. 1 und 2,
Fig. 4 einen Schnitt durch eine weitere Ausführungsform eines Trägers mit Lagereinheit und Antriebsmotor entlang der Linie IV-IV in Fig. 5 und
Fig. 5 eine Draufsicht auf die Träger aus Fig. 4, wobei zur besseren Darstellung Teile des Trägers nicht dargestellt sind.

Ein in Fig. 1 gezeigter Träger 1 ist rotationssymmetrisch ausgebildet und besteht aus einem inneren, vorzugsweise aus Metall gefertigten Teil 2 und einem äußeren, etwa topfförmigen, vorzugsweise aus Kunststoff bestehenden Teil 3. Der innere Teil 2 sitzt mit einem Ansatz 4 auf einer nach oben gerichteten Fläche 5 des äußeren Teils 3 auf, so daß die Relativlage der Teile 2 und 3 zueinander definiert ist.

Zwischen den beiden Teilen 2 und 3 des Trägers 1 ist ein Raum 6 vorgesehen, in den über eine hohl ausgebildete Welle 7 unter Druck stehendes Gas, wie beispielsweise Luft oder Stickstoff eingeführt werden kann. Der Raum 6 mündet in eine Ringdüse 8 aus, deren von den Teilen 2 und 3 gebildete Begrenzungswände mit der oberen Fläche des Trägers 1 einen spitzen Winkel α einschließen.

Die obere Endfläche des Trägers 1 wird von einer Kreisringfläche 9 des Teils 3 und einer Kreisfläche 10 des Teils 2 gebildet. Zwischen der Kreisringfläche 9 und der Kreisfläche 10 mündet die Ringdüse 8 an der Oberseite des Trägers 1 aus.

Von der Kreisringfläche 9 ragen Nocken 9' nach oben, die zur seitlichen Abstützung eines auf dem Träger 1 angeordneten, kreisrunden scheibenförmigen Gegenstandes 11 dienen. Der scheibenförmige Gegenstand 11 wird durch das über die Hohlwelle 7 zugeführte und aus der Düse 8 austretende Gas von der ihm zugekehrten Fläche des Trägers 1 (Kreisringfläche 9 und Kreisfläche 10) im Abstand S gehalten. Durch die besondere Ausbildung der Ringdüse 8 ergibt sich beim Ausströmen des Gases im Bereich D der dem Gegenstand 11 zugekehrten Fläche 9, 10 des Trägers 1 ein Unterdruck, durch den der scheibenförmige Gegenstand 11 niedergehalten und vom aus der Ringdüse 8 ausströmenden Gas nicht weggeblasen wird. Dabei ergibt sich der Vorteil, daß der Abstand S vom Druck des dem Raum 6 zugeführten, und aus der Ringdüse 8 ausströmenden Gases, weitgehend unabhängig ist.

In Fig. 1 ist noch gezeigt, daß über dem scheibenförmigen Gegenstand eine Leitung 12 ausmündet, durch die der oberen Fläche des scheibenförmigen Gegenstandes 11 eine Behandlungsflüssigkeit 13, beispielsweise eine Säure zum Ätzen einer Siliziumscheibe zugeführt werden kann. In Fig. 1 ist auch gezeigt, daß die auf den scheibenförmigen Gegenstand 11 aufgebrachte Behandlungsflüssigkeit auf seiner Oberseite einen Flüssigkeitsfilm bildet, dessen Dicke und Gleichmäßigkeit über die gesamte Fläche von der aufgebrachten Menge an Behandlungsflüssigkeit und der Drehzahl des Trägers 1 um seine Achse 14 abhängt. Der Film aus Behandlungsflüssigkeit reißt an der Außenkante des scheibenförmigen Gegenstandes 11 ab, und die Tröpfchen 15 werden zusätzlich vom aus der Ringdüse 8 ausströmenden Gas, wie in Fig. 1 angedeutet, weggeblasen, so daß die untere Seite des scheibenförmigen Gegenstandes 11 mit Behandlungsflüssigkeit nicht benetzt wird.

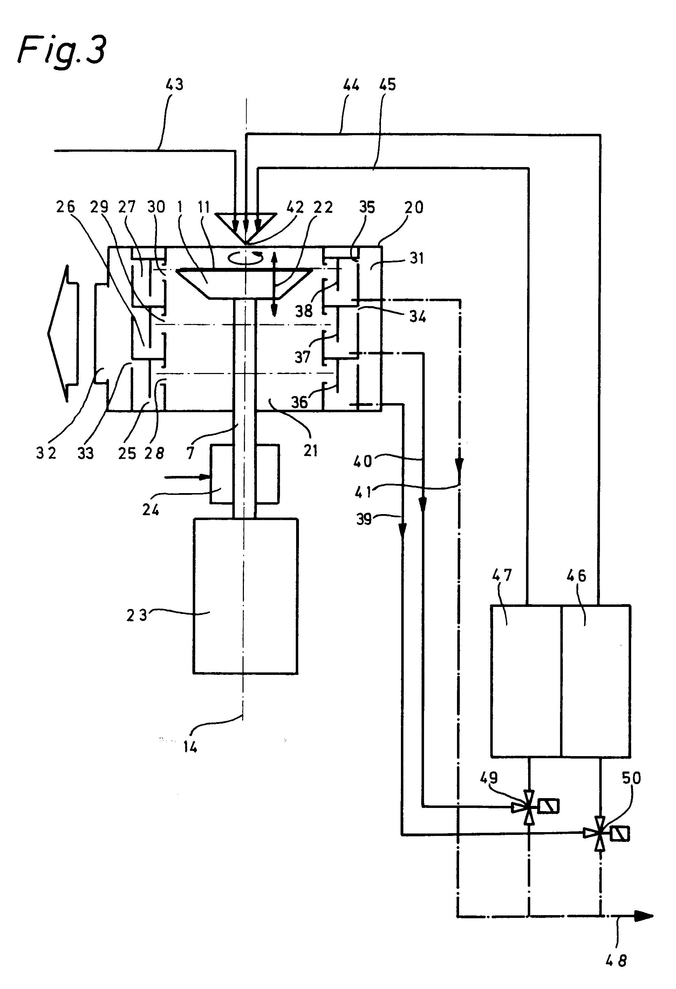

Eine in Fig. 3 gezeigte Vorrichtung zum Ätzen von Siliziumscheiben - diese Vorrichtung kann sinngemäß auch zur Behandlang von anderen scheibenförmigen Gegenständen mit unterschiedlichen Behandlungsflüssigkeiten eingesetzt werden - besteht aus einem Topf 20, in dessen Innenraum 21 der Träger 1 in Richtung des Doppelpfeiles 22 heb- und senkbar aufgenommen ist. Hiezu ist der die Welle 7 antreibende Motor 23 durch einen nicht näher gezeigten Antrieb auf- und abbeweglich.

Der Welle 7 ist eine Manschette 24 zugeordnet, über die in den in ihr vorgesehenen Hohlraum Druckgas, wie Druckluft oder Stickstoff zugeführt werden kann. Hiezu ist die Manschette 24 an eine Druckgasquelle angeschlossen.

Im Topf 20 sind übereinander drei Kanäle 25, 26 und 27 vorgesehen. Die ringförmigen Kanäle 25, 26 und 27 sind über ringförmige Schlitze 28, 29 und 30 zum Innenraum 21 des Topfs 20 offen.

Außerhalb der Kanäle 25, 26 und 27 ist im Topf 20 ein Ringraum 31 vorgesehen, der über einen Stutzen 32 an eine Absaugeinrichtung angeschlossen ist. Die Kanäle 25, 26 und 27 sind über Öffnungen 33, 34 und 35 mit dem Ringraum 31 verbunden.

In jedem Kanal 25, 26 und 27 sind Blenden 36, 37 und 38 vorgesehen, die im Abstand über dem Boden jedes Kanals 25, 26 und 27 enden. Diese Blenden 36, 37 und 38 verhindern, daß vom auf dem Träger 1 angeordneten scheibenförmigen Gegenstand, beispielsweise der Siliziumscheibe, abgeschleuderte Flüssigkeit unmittelbar zu den Austrittsöffnungen 33, 34 und 35 der Kanäle 25, 26 und 27 gelangen kann.

Von den Kanälen 25, 26 und 27 führen Leitungen 39, 40 und 41 weg.

Oberhalb des Trägers 1 münden, vorzugsweise in einer gemeinsamen Öffnung 42 Leitungen 43, 44 und 45 aus. Die Mündung bzw. die Mündungen der Leitungen 43, 44 und 45 sind gemeinsam mit dem Träger 1 gegenüber dem Topf 20 höhenverstellbar, um den Relativabstand zwischen dem Träger 1 und der Mündung 42 konstant zu halten. Über die Leitung 43 kann Spülwasser, beispielsweise deionisiertes Wasser zugeführt werden. Die Leitungen 44 und 45 gehen von Behältern 46 und 47 aus, in welchen die Behandlungsflüssigkeiten, z.B. Säuren vorrätig gehalten werden.

Die Leitung 41 vom Kanal 27 ist an eine Entsorgungsleitung 48 angeschlossen. Die Leitung 40 führt zu einem Dreiwegeventil 49 und die Leitung 39 zu einem Dreiwegeventil 50. Durch entsprechende Einstellung der Ventile 49 bzw. 50 kann aus den Kanälen 25 und/oder 26 abgezogene Flüssigkeit (Säure) entweder in die Vorratsbehälter 46 bzw. 47 rückgeführt oder zur Entsorgungsleitung 48 zugeführt werden.

In den Kanälen 25, 26 und 27 kondensieren die von der am Träger 1 angeordneten Siliziumscheibe abgeschleuderten feinen Säuretröpfchen bzw. Flüssigkeitströpfchen und die Flüssigkeiten werden dann über die Leitungen 39, 40 und 41 abgezogen.

Zum Transportieren der Flüssigkeiten können nicht näher gezeigte Pumpen vorgesehen sein.

Die Absaugeinrichtung, bestehend aus dem Ringraum 31 und dem Stutzen 32, der zu einer Saugpumpe führt, gewährleistet während des Betriebes der Vorrichtung eine definierte Luftströmung.

Nach dem Spülen des scheibenförmigen Gegenstandes 11 (Siliziumscheibe), während welchen Vorganges der Träger 1, wie in Fig. 3 dargestellt, gegenüber dem Kanal 27 ausgerichtet ist, wird die Drehzahl des Trägers 1 erhöht, so daß die Scheibe 11 durch Schleudern bei hoher Drehzahl getrocknet wird, ehe sie zur Entladung freigegeben wird.

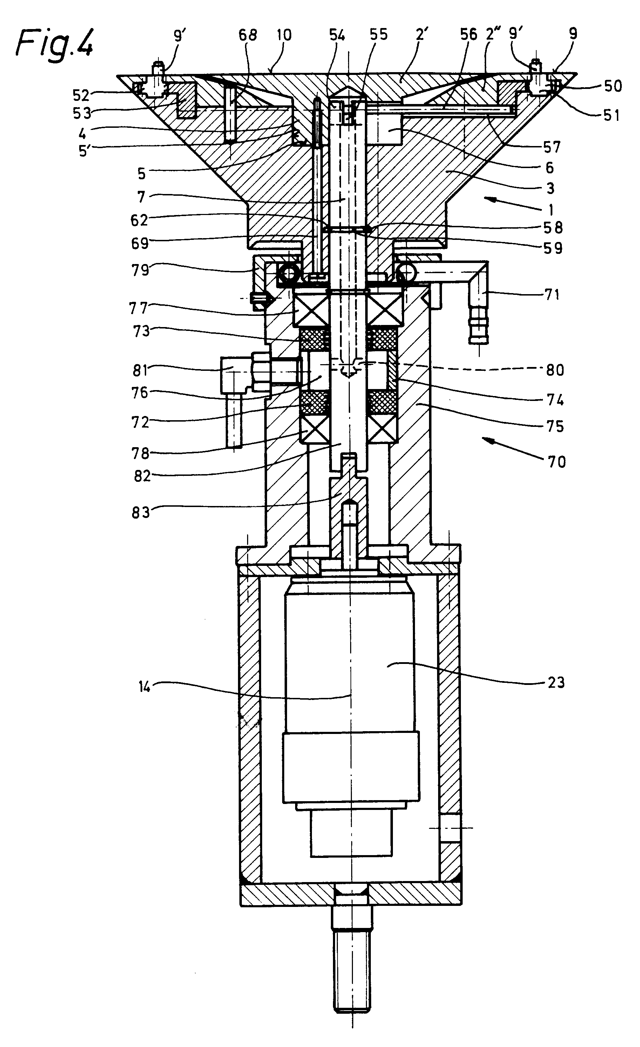

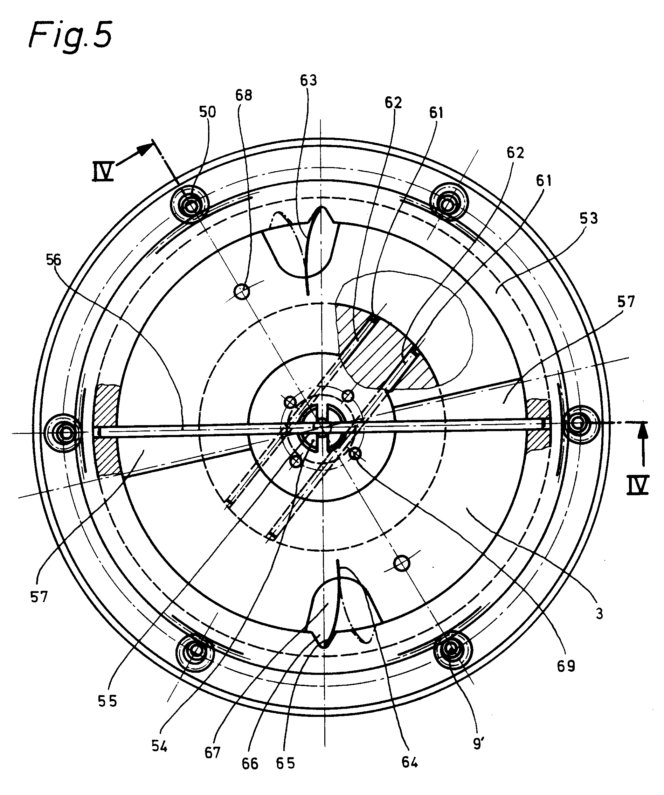

Bei der in den Fig. 4 und 5 dargestellten Ausführungsvariante des Trägers 1 ist der Teil 2 durch einen Drehscheibenoberteil 2'' und einen Deckel 2' ersetzt. Der Deckel 2' bildet die Kreisfläche 10 und der Drehscheibenoberteil 2'' die Kreisringfläche 9. Die Ringdüse 8 wird von den Begrenzungswänden des Drehscheibenoberteils 2'' und des Deckels 2' gebildet. Zwischen dem Drehscheibenoberteil 2'' und dem Teil 3 sind ein Zahnkranz 53 und die die Nocken 9' und Ritzel 52 tragenden Wellen 50 gelagert. Die Ritzel 52 der Wellen 50 und der Zahnkranz 53 sind miteinander im Eingriff. Die Nocken 9' sind exzentrisch auf den Wellen 50 angeordnet, so daß sich der radiale Abstand der Nocken 9' von der Mittelachse 14 bei Verdrehung der Wellen 50 durch den Zahnkranz 53 verändert.

Der Drehscheibenoberteil 2'' wird durch zwei Paßstifte 68 und einen nicht näher dargestellten Schnappverschluß am Teil 3 befestigt.

Der Deckel 2' ist durch den Ansatz 4 über eine nach oben gerichtete Fläche 5 und eine zylindrische Fläche 5' des Teiles 3 gelagert, so daß die Relativlage des Deckels 2' und des äußeren Teiles 3 zueinander definiert ist. Der Deckel 2' und der äußere Teil 3 sind durch vier Schrauben 69 in axialer Richtung fest miteinander verbunden. Durch das Einfügen von Beilagscheiben zwischen den Ansatz 4 des Deckels 2' und die Fläche 5 des äußeren Teiles 3 ist die Relativlage des Deckels 2' zum äußeren Teil 3 in axialer Richtung veränderbar, wodurch die Breite des Ringspaltes 8 zwischen dem Deckel 2' und dem Drehscheibenoberteil 2'' veränderbar ist.

Die Verdrehung der Nocken 9' auf den Wellen 50 erfolgt über den Zahnkranz 53. Der Antrieb des Zahnkranzes 53 erfolgt über eine Stange 56 durch die hohl ausgebildete Welle 7. Die Stange 56 ist mit ihren beiden Enden in Bohrungen, die im Zahnkranz 53 vorgesehen sind, und in einem Schlitz 55, der im Ende 54 der Welle 7 vorgesehen ist, gelagert. Der Schlitz 55, der zum Ende 54 der Welle 7 hin offen ist und in einer Axialebene der Welle 7 liegt, ermöglicht ein problemloses Aufschieben der Welle 7 auf die Stange 56. Weiters wird dadurch auch gewährleistet, daß der Deckel 2' gegenüber dem äußeren Teil 3 zur Veränderung der Breite des Ringspaltes 8 in axialer Richtung verschiebbar ist.

Um eine Verdrehung des Zahnkranzes 53 durch die Stange 56 zu ermöglichen, sind an der Oberseite des äußeren Teiles 3 kreisringstückförmige Ausnehmungen 57 vorgesehen, in denen sich die Stange 56 bei Verdrehung um die Mittelachse 14 bewegen kann. Diese Ausnehmungen 57 sind im besonderen aus Fig. 5 ersichtlich, in der zur besseren Darstellung der Deckel 2' und der Drehscheibenoberteil 2'' nicht gezeigt sind.

Um die Hohlwelle 7 im äußeren Teil 3 in axialer Richtung festzulegen, sind in der Welle 7 eine Ringnut 59 und in der Bohrung für die Welle 7 im äußeren Teil 3 eine Ringnut 58 vorgesehen, die einander gegenüberliegen. Weiters sind im äußeren Teil 3 zwei zueinander parallele, durch den Teil 3 gehende Bohrungen 61 vorgesehen, die zu beiden Seiten der Welle 7 liegen, mit ihren Mittelachsen die Welle 7 tangieren und durch die Ringnuten 58 und 59 durchführen. In die Bohrungen 61 werden Federstahlstifte 62 eingeführt, die durch die Ringnuten 58, 59 ragen und somit die hohle Welle 7 an einer axialen Verschiebung gegenüber dem äußeren Teil 3 hindern. Die äußeren Enden der Bohrungen 61 können z.B. verschweißt werden, um ein Herausfallen der Federstahlstifte 62 zu verhindern. Durch die erfindungsgemäße Ausführungsform dieser Befestigungseinrichtung ist es möglich, durch Aufbringung einer größeren Kraft, als sie beim Betrieb des Trägers auftritt, den Träger 1 von der Welle 7 in axialer Richtung abzuziehen, wobei die Federstahlstifte 62 aus der Ringnut 59 der Welle 7 hinausgedrückt werden.

Das untere Ende des äußeren Teiles 3 des Trägers 1 ragt in eine Lagereinheit 70, in der die Welle 7 durch zwei Lager 77, 78 gelagert ist. Das untere Ende des Trägers 1 ragt in das obere Ende dem Lagereinheit 70 hinein. Zwischen dem unteren Ende des Trägers 1 und dem oberen Ende der Lagereinheit 70 ist eine Schlauchbremse 71 angeordnete, die das untere Ende des Trägers 1 umfaßt. Das obere Ende der Lagereinheit 70 ist durch einen kreisringförmigen Deckel 79 abgeschlossen, der das Herausrutschen der Schlauchbremse 71 verhindert.

Die Zufuhr des Druckgases in die hohle Welle 7 erfolgt in der Lagereinheit 70 zwischen den beiden Lagern 77 und 78. Dazu ist ein Ringraum 76 vorgesehen, der durch zwei Labyrinthdichtungen 72, 73, eine Hülse 74, die an der Innenseite der Gehäusewand 75 der Lagereinheit 70 anliegt, und die Welle 7 begrenzt wird. Der Ringraum 76 ist mit der Bohrung in der Welle 7 durch Bohrungen 80 verbunden. Die Zufuhr des Druckgases in den Ringraum 76 erfolgt durch eine Bohrung in der Gehäusewand 75 und eine Ausnehmung in der Hülse 74 über ein Anschlußstück 81, das in die Gehäusewand 75 eingeschraubt ist.

Die hohle Welle 7 ist an ihrem unteren Ende 82 über eine Kupplung 83 mit dem Motor 23 verbunden, der an der Lagereinheit 70 befestigt ist.

Die Bewegung der Nocken 9' erfolgt auf folgende Weise: Im Betrieb sind die Nocken 9' z.B. in der in Fig. 5 dargestellten radial innersten Lage. Der Träger 1 wird nun aus seiner Drehbewegung bis zum Stillstand abgebremst. Die Schlauchbremse 71 wird unter Druck gesetzt und hält den Träger 1 in seiner Relativlage zur Lagereinheit 70 fest. Der Motor 23 dreht nun kurz in die der Arbeitsdrehrichtung entgegengesetzte Drehrichtung. Diese Bewegung wird über die Welle 7 und die Stange 56 auf den Zahnkranz 53 übertragen. Die Stange 56 bewegt sich dabei in den kreisringstückförmigen Ausnehmungen 75 im äußeren Teil 3. Durch die Drehbewegung des Zahnkranzes 53 relativ zum äußeren Teil 3 bzw. dem Deckel 2' und dem Drehscheibenoberteil 2'' werden über die Ritzel 52 der Wellen 50 die Nocken 9' aus ihrer Arbeitsstellung in eine radial weiter außen liegende Stellung gedreht. Nun ist ein einfaches Wechseln des scheibenförmigen Gegenstandes 11 möglich. Anschließend beginnt sich der Motor 23 wieder in seine Arbeitsdrehrichtung zu drehen. Die Schlauchbremse 71 wird dabei noch kurzfristig unter Druck gehalten. Durch die dadurch entstehende Relativbewegung des Zahnkranzes 53 gegenüber dem Träger 1 werden die Nocken 9 wieder in ihre radial innere Stellung gedreht. Die Schlauchbremse 71 wird wieder gelöst und die Bearbeitung des nun eingespannten scheibenförmigen Gegenstandes 11 kann durchgeführt werden.

Die Öffnungs- und Schließbewegung der Nocken 9 kann noch durch zwei Blattfedern 63 unterstützt werden, die zwischen dem äußeren Teil 3 und dem Zahnkranz 53 wirken. Die beiden Blattfedern 63 sind mit ihrem einen Ende 64 in einen Schlitz im äußeren Teil 3 eingepreßt. Mit ihrem anderen Ende 65 greifen sie in eine Ausnehmung 66 im Zahnkranz 53 ein. Die beiden Blattfedern 63 stehen dabei vorzugsweise unter Vorspannung. Um eine Bewegung der Federn 63 zu ermöglichen, sind im äußeren Teil 3 Ausnehmungen 67 vorgesehen, die den Ausnehmungen 66 im Zahnkranz 53 gegenüberliegen.

## Patentansprüche

1. Träger (1) für scheibenförmige Gegenstände (11), insbesondere für Siliziumscheiben während des Ätzens derselben, mit wenigstens einer Ringdüse (8), in der dem Gegenstand (11) zugekehrten, vorzugsweise kreisrunden Fläche (9, 10) des Trägers (1), die mit Druckgas zur Ausbildung eines Gaspolsters zwischen dem Träger (1) und dem scheibenförmigen Gegenstand (11) beaufschlagbar ist, und deren Austrittsöffnung mit der dem Gegenstand (11) zugekehrten Fläche (9, 10) des Trägers (1) einen spitzen Winkel (α) einschließt, wobei der Träger (1) aus zwei oder drei rotationssymmetrischen, gleichachsigen Teilen (2, 2', 2'', 3) besteht, und wobei zwischen den Teilen (2, 2', 2'', 3) ein ringförmiger Raum (6) vorgesehen ist, der zur Ringdüse (8) ausmündet, dadurch gekennzeichnet, daß entlang des Randes der dem Gegenstand (11) zugekehrten Fläche (9, 10) des Trägers (1) gleichmäßig verteilte, nach oben vorstehende Nocken (9') zur seitlichen Abstützung des scheibenförmigen Gegenstandes (11) vorgesehen sind und daß die Nocken (9') bezüglich der Mittelachse (14) des Trägers (1) radial verstellbar sind.

2. Träger nach Anspruch 1, dadurch gekennzeichnet, daß der ringförmige Raum (6) von einem Deckel (2'), einem Drehscheibenoberteil (2'') und einem äußeren Teil (3) begrenzt wird.

3. Träger nach Anspruch 1 oder 2, dadurch gekennzeichnet, daß der Träger (1) am Ende einer hohl ausgebildeten Welle (7) angeordnet ist, deren Innenraum mit dem Raum (6) zwischen den Teilen (2, 2', 2'', 3) des Trägers (1) zur Beaufschlagung mit Druckgas in Verbindung steht.

4. Träger nach Anspruch 1 oder 3, dadurch gekennzeichnet, daß der äußere Teil (3) des Trägers eine Ringfläche (9) aufweist, die den radial äußeren Bereich der dem Gegenstand (11) zugekehrten Fläche des Trägers (1) bildet, wobei dieser Teil (3) vorzugsweise aus Kunststoff gefertigt ist.

5. Träger nach einem der Ansprüche 2 bis 4, dadurch gekennzeichnet, daß der Deckel (2') eine Kreisfläche (10) aufweist, die den radial inneren Bereich der dem Gegenstand (11) zugekehrten Fläche des Trägers (1) bildet, wobei dieser Deckel (2') vorzugsweise aus Metall gefertigt ist.

6. Träger nach einem der Ansprüche 1 bis 5, dadurch gekennzeichnet, daß die Nocken (9') auf im Träger (1) verdrehbar gelagerten Wellen (50) zu deren Drehachse (51) exzentrisch angeordnet sind.

7. Träger nach Anspruch 6, dadurch gekennzeichnet, daß die Wellen (50) Ritzel (52) tragen, die mit einem im Träger (1) um dessen Mittelachse (14) verdrehbar gelagerten Zahnkranz (53) kämmen.

8. Träger nach Anspruch 7, dadurch gekennzeichnet, daß der Zahnkranz (53) mit der Welle (7) durch eine Stange (56) drehfest verbunden ist.

9. Träger nach Anspruch 8, dadurch gekennzeichnet, daß im im Deckel (2') gelagerten Ende (54) der Welle (7) wenigstens ein Schlitz (55) vorgesehen ist, der zum Ende (54) der Welle (7) hin offen ist und in einer in der Mittelachse (14) liegenden Ebene liegt.

10. Träger nach Anspruch 9, dadurch gekennzeichnet, daß die Stange (56) in den Schlitz (55) der Welle (7) eingreift.

11. Träger nach Anspruch 8, dadurch gekennzeichnet, daß die Stange (56) mit ihren beiden Enden in im Zahnkranz (53) vorgesehene Bohrungen eingreift.

12. Träger nach einem der Ansprüche 1 bis 11, dadurch gekennzeichnet, daß im äußeren Teil (3) kreisringstückförmige Ausnehmungen (57) für die Bewegung der Stange (56) bei Drehung des Zahnkranzes (53) um die Mittelachse (14) vorgesehen sind.

13. Träger nach einem der Ansprüche 1 bis 12, dadurch gekennzeichnet, daß im äußeren Teil (3) in der Bohrung für die Welle (7) eine Ringnut (58), an der Welle (7) eine Ringnut (59) und im äußeren Teil (3) zwei zueinander parallele, durch den Teil (3) durchgehende Bohrungen (61), deren Mittelachsen die Welle (7) tangieren, vorgesehen sind, wobei die Ringnuten (58, 59) und die Bohrungen (61) in einer zur Mittelachse (14) normalen Ebene liegen.

14. Träger nach Anspruch 13, dadurch gekennzeichnet, daß in die Bohrungen (61) Federstahlstifte (62) eingesetzt sind, die durch die Ringnuten (58, 59) ragen.

15. Träger nach einem der Ansprüche 1 bis 14, dadurch gekennzeichnet, daß wenigstens eine, vorzugsweise zwei Blattfedern (63) vorgesehen sind, die mit einem Ende (64) in den äußeren Teil (3) eingepreßt sind und mit dem anderen Ende (65) in eine Ausnehmung (66) im Zahnkranz (53) eingreifen, wobei die Federn unter Vorspannung stehen.

16. Träger nach Anspruch 15, dadurch gekennzeichnet, daß im äußeren Teil (3) Ausnehmungen (67) vorgesehen sind, die den Ausnehmungen (66) im Zahnkranz (53) gegenüberliegen.

17. Träger nach einem der Ansprüche 1 bis 16, dadurch gekennzeichnet, daß der äußere Teil (3) mit dem Drehscheibenoberteil (2'') durch wenigstens einen, vorzugsweise zwei Paßstifte (68) drehfest verbunden ist.

18. Träger nach einem der Ansprüche 1 bis 17, dadurch gekennzeichnet, daß der äußere Teil (3) mit dem Deckel (2') durch wenigstens eine, vorzugsweise vier Zylinderschrauben (69) verbunden ist.

19. Träger nach einem der Ansprüche 1 bis 18, dadurch gekennzeichnet, daß zwischen der Lagereinheit (70) für den Motor (23) und die Welle (7) und dem äußeren Teil (3) eine ringförmige, den äußeren Teil (3) umfassende Schlauchbremse (71) vorgesehen ist.

20. Träger nach einem der Ansprüche 1 bis 19, dadurch gekennzeichnet, daß zur Zufuhr des Druckgases in die hohle Welle (7) ein Ringraum (76) vorgesehen ist, der durch zwei Labyrinthdichtungen (72, 73), eine Hülse (74), die an der Innenseite der Gehäusewand (75) der Lagereinheit (70) anliegt, und die Welle (7) begrenzt wird, und der mit der Bohrung in der hohlen Welle (7) in Verbindung steht.

## Claims

1. Carrier (1) for disc-like articles (11), particularly for silicon discs during etching of the same, with at least one annular nozzle (8) in the preferably circular surface (9, 10) of the carrier (1) facing the article (11), said nozzle being chargeable with pressurised gas in order to form a gas buffer between the carrier (1) and the disc-like article (11), and whose outlet opening forms an acute angle (α) with the surface (9, 10) of the carrier (1) facing the article (11), the carrier (1) comprising two or three rotationally symmetrical, coaxial portions (2, 2', 2'', 3), there being provided between the portions ( 2, 2', 2'', 3) an annular space (6) which opens out to the annular nozzle (8), characterised in that there are provided, along the edge of the surface (9, 10) of the carrier (1) facing the article (11), uniformly-distributed, upwardly-projecting cams (9') for laterally supporting the disc-like article (11), and in that the cams (9') are displaceable radially with respect to the central axis (14) of the carrier (1).

2. Carrier according to claim 1, characterized in that the annular space (6) is defined by a cap (2'), a rotary disc upper portion (2''), and an external portion (3).

3. Carrier according to claim 1 or 2, characterised in that the carrier (1) is disposed at the end of a hollow shaft (7) whose inner space communicates with the space (6) between the portions (2, 2', 2'', 3) of the carrier (1) for charging with pressurised gas.

4. Carrier according to claim 1 or 3, characterised in that the external portion (3) of the carrier has an annular surface (9) forming the radially outward region of the surface of the carrier (1) facing the article (11), said portion (3) preferably being made of plastics material.

5. Carrier according to one of claims 2 to 4, characterised in that the cap (2') has a circular surface (10) forming the radially inward region of the surface of the carrier (1) facing the article (11), said cap (2') preferably being made of metal.

6. Carrier according to one of claims 1 to 5, characterised in that the cams (9') are mounted on shafts (50) rotatably mounted in the carrier (1), eccentrically to the axis of rotation of the shafts.

7. Carrier according to claim 6, characterised in that the shafts (50) carry pinions (52) which mesh with a toothed ring (53) mounted in the carrier (1) to rotate about its central axis (14).

8. Carrier according to claim 7, characterised in that the toothed ring (53) is non-rotarily connected to the shaft (7) by a rod (56).

9. Carrier according to claim 8, characterised in that there is provided, in the end (54) of the shaft (7) mounted in the cap (2') at least one slot (55) which is open towards the end (54) of the shaft (7) and lies in a plane located in the central axis (14).

10. Carrier according to claim 9, characterised in that the rod (56) engages in the slot (55) in the shaft (7).

11. Carrier according to claim 8, characterised in that rod (56 ) engages with both ends in bores provided in the toothed ring (53).

12. Carrier according to one of claims 1 to 11, characterised in that there are provided, in the external portion (3), segment-shaped recesses (57) for movement of the rod (56) upon rotation of the toothed ring (53) about the central axis (14).

13. Carrier according to one of claims 1 to 12, characterised in that there are provided, in the external portion (3), in the bore for the shaft (7) an annular groove (58), on the shaft (7) an annular groove (59) and in the external portion (3) two mutually-parallel bores (61), passing through the portion (3), the central axes of which are tangential to the shaft (7), the annular grooves (58, 59) and the bores (61) lying in a plane normal to the central axis (14).

14. Carrier according to claim 13, characterised in that spring steel pins (62) projecting through the annular grooves (58, 59) are inserted in the bores (61).

15. Carrier according to one of claims 1 to 14, characterised in that there are provided at least one, preferably two leaf springs (63), which are pressed at one end (64) into the external portion (3) and engage with the other end (65) in a recess (66) in the toothed ring (53), the said springs being pre-tensioned.

16. Carrier according to claim 15, characterised in that there are provided in the external portion (3) recesses (67) which lie opposite the recesses (66) in the toothed ring (53).

17. Carrier according to one of claims 1 to 16, characterised in that the external portion (3) is non-rotarily connected to the rotary disc upper portion (2'') by at least one, preferably two dowel pins (68).

18. Carrier according to one of claims 1 to 17, characterised in that the external portion (3) is connected to the cap (2') by at least one, preferably four machine screws (69).

19. Carrier according to one of claims 1 to 18, characterised in that there is provided, between the bearing unit (70) for the motor (23) and the shaft (7), and the external portion (3), an annular hose brake (71) surrounding the external portion (3).

20. Carrier according to one of claims 1 to 19, characterised in that , in order to supply the pressurised gas to the hollow shaft (7), there is provided an annular space (76), defined by two labyrinth seals (72, 73), a sleeve (74) which abuts against the internal side of the housing wall (75) of the bearing unit (70), and the shaft (7), said annular space (76) communicating with the bore in the hollow shaft (7).

## Revendications

1. Support (1) destiné à supporter des objets (11) en forme de disque, en particulier des disques de silicium, pendant l'attaque chimique de ceux ci, comportant dans la surface (9, 10) de préférence circulaire du support (1) tournée vers l'objet (11), au moins une buse annulaire (8) qui peut être alimentée en gaz sous pression pour former un coussin de gaz entre le support (1) et l'objet (11) en forme de disque et dont l'orifice de sortie forme un angle (α) aigu avec la surface (9, 10) du support (1) tournée vers l'objet (11), le support (1) étant formé de deux ou trois parties (2, 2', 2'', 3) symétriques de rotation ayant un axe commun et une chambre (6) annulaire qui mène à la buse annulaire (8) étant prévue entre les parties (2, 2', 2'', 3), caractérisé par le fait qu'il est prévu le long du bord de la surface (9, 10) du support (1) tourné vers l'objet (11) des cames (9') qui sont réparties unifo- rmément, font saillie vers le haut et sont destinées à supporter latéralement l'objet (11) en forme de disque et par le fait que les cames (9') peuvent être déplacées radialement par rapport à l'axe médian (14) du support (1).

2. Support selon la revendication 1, caractérisé par le fait que la chambre annulaire (6) est délimitée par un couvercle (2'), une partie supérieure (2'') de plateau tournant et une partie extérieure (3).

3. Support selon la revendication 1 ou 2, caractérisé par le fait que le support (1) est monté à l'extrémité d'un arbre (7) creux dont le volume intérieur communique avec la chambre (6) entre les parties (2, 2', 2'', 3) du support (1) à des fins d'introduction de gaz sous pression.

4. Support selon la revendication 1 ou 3, caractérisé par le fait que la partie extérieure (3) du support présente une surface annulaire (9) qui constitue la zone située radialement à l'extérieur de la surface du support (1) tournée vers l'objet (11), la partie (3) étant de préférence réalisée en matière plastique.

5. Support selon l'une des revendications 2 à 4, caractérisé par le fait que le couvercle (2') présente une surface circulaire (10) qui constitue la zone située radialement à l'intérieur de la surface du support (1), tournée vers l'objet (11), le couvercle (2') étant de préférence réalisé en métal.

6. Support selon l'une des revendications 1 à 5, caractérisé par le fait que les cames (9') sont montées sur des axes (50) montés tournant dans le support (1) en étant excentrées par rapport à l'axe de rotation (51).

7. Support selon la revendication 6, caractérisé par le fait que les axes (50) portent des pignons (52) qui engrènent avec une couronne dentée (53) montée tournante dans le support (1) autour de l'axe médian (14) dudit support.

8. Support selon la revendication 7, caractérisé par le fait que la couronne dentée (53) est rendue solidaire en rotation de l'arbre (7) par une tige (56).

9. Support selon la revendication 8, caractérisé par le fait qu'il est prévu dans l'extrémité (54) de l'arbre (7) monté dans le couvercle (2') au moins une fente (55) qui est ouverte en direction de l'extrémité (54) de l'arbre (7) et est située dans un plan passant par l'axe médian (14').

10. Support selon la revendication 9, caractérisé par le fait que la tige (56) pénètre dans la fente (55) de l'arbre (7).

11. Support selon la revendication 8, caractérisé par le fait que la tige (56) pénètre par ses deux extrémités dans des trous prévus dans la couronne dentée (53).

12. Support selon l'une des revendications 1 à 11, caractérisé par le fait qu'il est prévu dans la partie extérieure (3) des évidements (57) en forme de secteur de cercle pour le déplacement de la tige (56) lorsque la couronne dentée (53) tourne autour de l'axe médian (14).

13. Support selon l'une des revendications 1 à 12, caractérisé par le fait qu'il est prévu dans la partie extérieure (3), dans le trou recevant l'arbre (7), une gorge annulaire (58), sur l'arbre (7), une gorge annulaire (59) et dans la partie extérieure (3) deux trous (61) parallèles entre eux qui traversent la partie (3) et dont les axes médians sont tangents à l'arbre (7), les gorges annulaires (58, 59) et les trous (61) étant situés dans un plan normal à l'axe médian (14).

14. Support selon la revendication 13, caractérisé par le fait que des goupilles (62) en acier à ressort sont placées dans les trous (61), lesquelles goupilles font saillie dans les gorges annulaires (58, 59).

15. Support selon l'une des revendications 1 à 14, caractérisé par le fait qu'il est prévu au moins un, de préférence deux ressorts à lame (63) dont une extrémité (64) est engagée à force dans la partie (3) extérieure et dont l'autre extrémité (65) pénètre dans un évidement (66) de la couronne dentée (53) les ressorts étant mis en précontrainte.

16. Support selon la revendication 15, caractérisé par le fait qu'il est prévu dans la partie (3) extérieure, des évidements (67) qui sont situés en regard des évidements (66) de la couronne dentée (53).

17. Support selon l'une des revendications 1 à 16, caractérisé par le fait que la partie (3) extérieure est rendue solidaire en rotation de la partie supérieure (2'') du plateau tournant par au moins une, de préférence deux goupilles ajustées (68).

18. Support selon l'une des revendications 1 à 17, caractérisé par fait que la partie (3) extérieure est liée au couvercle (2') par au moins une, de préférence quatre vis à tête cylindrique (69).

19. Support selon l'une des revendications 1 à 18, caractérisé par le fait qu'il est prévu entre l'ensemble palier (70) pour le moteur (23) et l'arbre (7) et la partie (3) extérieure un frein à boudin gonflable (71) annulaire qui entoure la partie extérieure (3).

20. Support selon l'une des revendications 1 à 19, caractérisé par le fait qu'il est prévu pour amener le gaz sous pression dans l'arbre creux (7), une chambre annulaire (76) qui est délimitée par deux joints à labyrinthe (72, 73), un manchon (74) qui est appliqué contre la face intérieure de la paroi de l'ensemble palier (70) et l'arbre (7) et communique avec l'alésage de l'arbre creux (7).
